# EUROPEAN PATENT APPLICATION

(11) **EP 2 610 703 A2**
(43) Date of publication of application: **03.07.2013**
(21) Application number: 12188309.4
(22) Date of filing: 12.10.2012
(51) Int. Cl.: G06F 1/32, G06F 1/28

(54) **Battery managing method and apparatus, and electronic device using the same**

(30) Priority: 27.12.2011 KR 20110143928
(71) Applicant: Samsung Electronics Co., Ltd, Gyeonggi-do 443-742 (KR)
(72) Inventor: Jang, Yong-ju, Gyeonggi-do (KR); Cha, Jae-deok, Gyeonggi-do (KR)
(74) Representative: Taor, Simon Edward William

(57) **Abstract**

A battery managing method and apparatus, and an electronic device using the method and apparatus, to manage a power consumption amount of a battery in the electronic device such that a user may use the electronic device for a desired time period. The power consumption of the battery in the electronic device is measured and the user is notified that the battery is being overly used based on the desired time period of the user such that the user may manage the battery consumption of the electronic device.

## Description

The present general inventive concept relates to a battery managing method and apparatus, and an electronic device using the same, and more particularly, to a battery managing method and apparatus, to notify a user that a battery is currently being overly used based on a predetermined time period to use the electronic device desired by the user, and an electronic device using the method and apparatus.

According to technological developments, various electronic devices are generated. The electronic devices commonly include a battery outputting a driving voltage for the electronic devices. With the appearance of new electronic devices, interest in batteries required to drive the electronic devices, as well as the electronic devices themselves, has increased. For example, interest in various characteristics of batteries, for example, a battery that may be used for a long time with only one charging, a battery having a long lifespan, and lightweight batteries has been increasing, and research thereon is being conducted.

On the other hand, technologies for detecting remaining capacity of a battery and displaying the detected capacity of the battery so that a user of the electronic device may determine an approximate usable period have been widely known.

The present general inventive concept provides a battery managing method and apparatus to allow a user to manage battery consumption of an electronic device so that the user may use the electronic device for a desired period of time, and an electronic device using the battery managing method and apparatus.

Additional features and utilities of the present general inventive concept will be set forth in part in the description which follows and, in part, will be obvious from the description, or may be learned by practice of the general inventive concept.

The foregoing and/or features and utilities of the present general inventive concept may be achieved by providing a battery managing method including measuring a power consumption amount of a battery in an electronic device, receiving an input of a desired usage time of the electronic device from a user of the electronic device, determining whether the battery is being overly used based on a reference power amount per unit time required to use the electronic device for the input usage time period and a power consumption amount per unit time, and notifying the user of a result of the determining.

The foregoing and/or features and utilities of the present general inventive concept may also be achieved by providing a battery managing apparatus including a measuring unit to measure a power consumption amount of a battery of an electronic device, a setting unit to receive a desired usage time of the electronic device from a user of the electronic device, a determination unit to determine whether the battery is being overly used, based on a reference power amount per unit time required to use the electronic device for the input usage time period and a power consumption amount per unit time, and a notification unit to notify the user of a result of the determining.

These and/or other features and utilities of the present general inventive concept will become apparent and more readily appreciated from the following description of the embodiments, taken in conjunction with the accompanying drawings of which:
FIG. 1 is a block diagram of a battery managing apparatus according to an embodiment of the present general inventive concept;
FIGs. 2A through 2D are diagrams of examples of a setting unit that is a component in the battery managing apparatus shown in FIG. 1;
FIGs. 3A through 3C are diagrams of examples of a notification unit that is a component in the battery managing apparatus of FIG. 1;
FIG. 4 is a block diagram of an electronic device including the battery managing apparatus of FIG. 1;
FIG. 5 is a diagram showing an example of an adjustment interface used in the electronic device of FIG. 4;
FIG. 6 is a diagram showing an example of realizing a setting unit of the battery managing apparatus as software in the electronic device shown in FIG. 4;
FIG. 7 is a flowchart illustrating a battery managing method according to an embodiment of the present general inventive concept; and
FIG. 8 is a flowchart illustrating a battery managing method according to an embodiment of the present general inventive concept.

Reference will now be made in detail to the embodiments of the present general inventive concept, examples of which are illustrated in the accompanying drawings, wherein like reference numerals refer to the like elements throughout. The embodiments are described below in order to explain the present general inventive concept while referring to the figures.

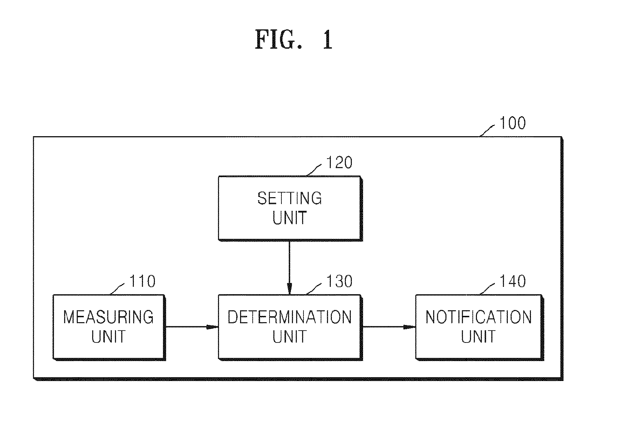

FIG. 1 is a block diagram of a battery managing apparatus 100 according to an embodiment of the present general inventive concept. Referring to FIG. 1, the battery managing apparatus 100 includes a measuring unit 110, a setting unit 120, a determination unit 130, and a notification unit 140. One of ordinary skill in the art may comprehend that universal components may be further included in the battery managing apparatus 100 in addition to the components shown in FIG. 1.

The battery managing apparatus 100 may be included in various electronic devices such as cellular phones, smart phones, personal digital assistants (PDAs), portable multimedia players (PMPs), MP3 players, laptop computers, tablet computers, navigators, digital cameras, and camcorders. One of ordinary skill in the art may appreciate that the battery managing apparatus 100 may be included in a fixed type terminal using batteries, as well as the above portable terminals.

The measuring unit 110 measures power consumption of a battery of the electronic device. The measuring unit 110 may be located between the battery and an internal system of the electronic device so as to detect a voltage or current output from the battery, thereby measuring the power consumption. For example, the measuring unit 110 may include a sensor resistor and a differential amplifier. The measuring unit 110 may measure the power consumption of the battery in real-time.

The setting unit 120 receives a usage time period that is a period of time a user desires to use the electronic device. The setting unit 120 may include a portion through which the usage time period is input and a portion displaying the input usage time period, and the above two portions may be separated or may be integrated from/with each other. The setting unit 120 may be realized in various ways, for example, a dial type, a button type, a switch type, and a sliding type. The various types of the setting unit 120 will be described later.

The determination unit 130 determines whether the battery is being overly used based on a reference power amount per unit time required to use the electronic device for the usage time input by the user and a power consumption amount per unit time.

In more detail, the determination unit 130 converts the measured power consumption amount into a power consumption amount per unit time. Here, the unit time may be input by the user or may be set in advance. The determination unit 130 calculates the reference power amount per unit time that is a power amount per unit time required to use the electronic device with a remaining capacity of the battery during a remaining time period until the input usage time period expires, and compares the power consumption amount per unit time with the reference power amount per unit time. According to a result of the comparison, the determination unit 130 determines whether the battery is being overly used. The determination unit 130 determines that the battery is being overly used when the power consumption amount per unit time exceeds the reference power amount per unit time. The above determination may be repeatedly performed before the input usage time period has expired, for example, the determination may be periodically performed at unit time intervals.

The determination unit 130 may be realized as software such as various firmware or a basic input/output system (BIOS), or hardware such as a control chip.

The notification unit 140 notifies the user of a result of the determination. Here, the notification is performed such that the user may distinguish a case where it is determined that the battery is being overly used from a case where it is determined that the battery is not being overly used. The notification may be performed by using colors or sound to stimulate senses of the user. For example, the notification unit 140 may use a light emission device that emits different colors corresponding to each of the determination results, and a plurality of the light emission devices may be used. Various ways of realizing the notification unit 140 will be described later.

The power consumption amount of the battery may be displayed to the user in real-time without regard to an operation system of the electronic device, and thus the user may easily know the usage status of the battery.

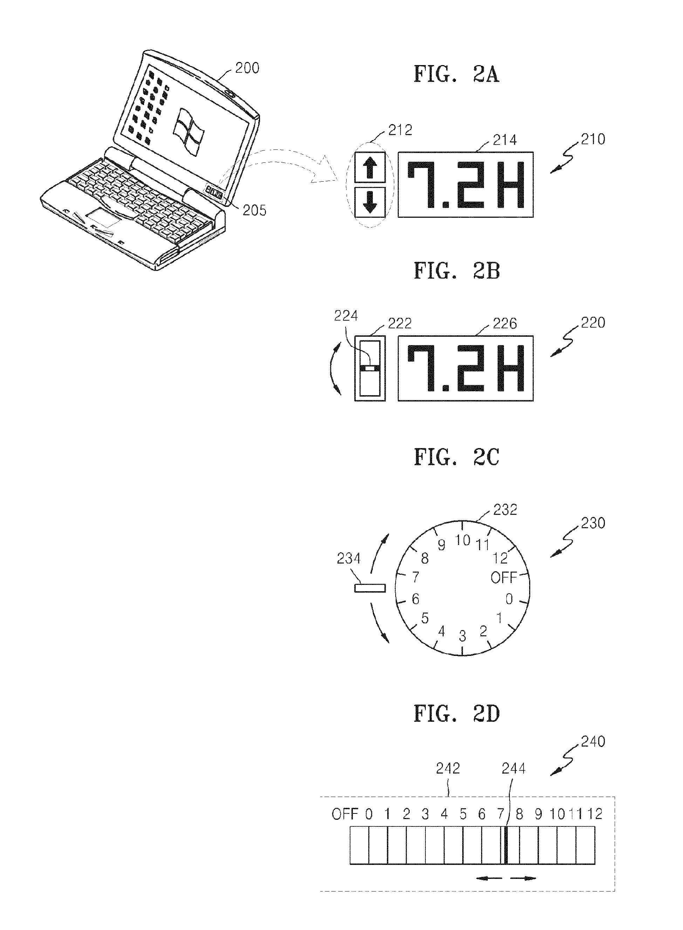

FIGS. 2A through 2D are diagrams showing examples of a setting unit 205 included in the battery managing apparatus 100 of FIG. 1. FIGS. 2A through 2D show an outer appearance of an electronic device 200, when the electronic device 200 includes the battery managing apparatus 100. As shown in FIGS. 2A through 2D, a setting unit 205 is located on an outer portion of the electronic device 200 so that the user may directly manipulate the setting unit 205. In FIGS. 2A through 2D, the electronic device 200 is a laptop computer, however, the present general inventive concept is not limited thereto. FIG. 2A shows a magnified view of the setting unit 205 located on the outer portion of the electronic device 200, and FIGS. 2B, 2C, and 2D are different examples of the setting unit 205.

FIG. 2A shows a button type setting unit 210. The button type setting unit 210 may include a button unit 212 and a setting display unit 214. The button unit 212 may include an up button and a down button, and when the user pushes the up button or the down button, the time displayed on the setting display unit 214 is increased or decreased, respectively. On the setting display unit 214, 7.2 H means that the time period input by the user is 7 hours and 12 minutes. After setting the usage time by pushing the button unit 212, the usage time may be decreased over time. That is, when 12 minutes has passed after setting of the usage time, numbers on the setting display unit 214 may be changed into 7.0 H.

FIG. 2B shows a switch type setting unit 220. The switch type setting unit 220 may include a switch unit 222 and a setting display unit 226. The switch unit 222 may include a lever switch 224, and time displayed on the setting display unit 226 may be increased or decreased by operating the lever switch 224 upward or downward, respectively. The setting display unit 226 is the same as the setting display unit 214 shown in FIG. 2A, and thus detailed descriptions will not be provided here.

FIG. 2C shows a dial type setting unit 230. The dial type setting unit 230 may include a dial unit 232 and an indicator unit 234. The dial unit 232 includes numbers around an edge of a circular dial, and the numbers denote the usage time. When the user rotates the dial unit 232 in a clockwise direction or in a counter-clockwise direction to locate the number desired by the user on a portion where the indicator unit 234 is located, the usage time is set. The dial unit 232 may be formed in other shapes, besides the circular shape shown in FIG. 2C. In addition, scales in the dial unit 232 may not be formed with equal intervals, unlike FIG. 2C. When the usage time is set, the dial unit 232 rotates according to a lapse of time, and when the set usage time expires, the indicator unit 234 indicates the numbed '0'. Among the scales in the dial unit 232, OFF is used when the setting unit 230 is not used.

FIG. 2D shows a sliding type setting unit 240. The sliding type setting unit 240 may include a scale display unit 242 and a slide unit 244. The scale display unit 242 becomes a path through which the slide unit 244 moves, and at the same time, displays scales representing the usage time. The slide unit 244 moves in a left-and-right direction, and the user may input the usage time by locating the slide unit 244 on a certain scale. When the usage time is set, the slide unit 244 moves in a direction in which numbers of the scales are reduced as time elapses, and when the set usage time expires, the slide unit 244 is located at a scale '0'. Among the scales in the sliding type setting unit 240, OFF is used when the setting unit 240 is not used.

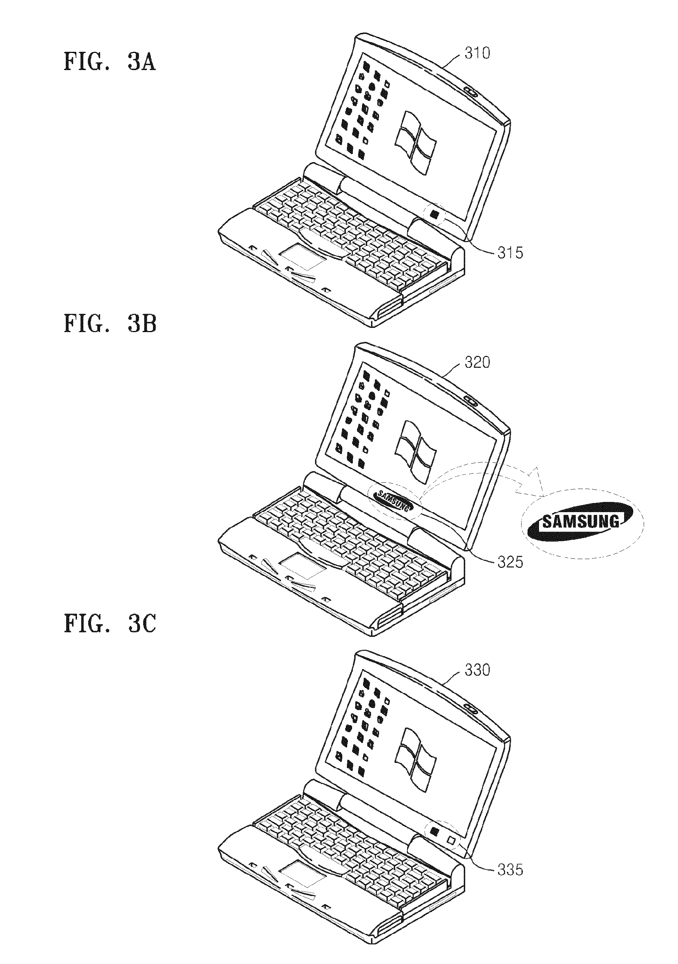

FIGS. 3A through 3C are diagrams showing examples of a notification unit in the battery managing apparatus 100 of FIG. 1. FIGS. 3A through 3C show outer appearances of electronic devices 310, 320, and 330 when the electronic devices 310, 320, and 330 include the battery managing apparatus 100. As shown in FIG. 3A through 3C, notification units 315, 325, and 335 may be located on outer portions of the electronic devices 310, 320, and 330 such that the user may sense the notification units 315, 325, and 335. In FIGS. 3A through 3C, the electronic devices 310, 320, and 330 are laptop computers, however, the present general inventive concept is not limited thereto. Types of the notification units 315, 325, and 335 located on the outer portions of the electronic devices 310, 320, and 330 may vary, and FIGS. 3A through 3C show different types of the notification units 315, 325, and 335.

FIG. 3A shows the notification unit 315 formed of a light emitting diode (LED) that may emit light of a plurality of colors on a right lower portion of a monitor of the electronic device 310. The LED may emit light beams of different colors when it is determined that the battery is being overly used and when it is determined that the battery is not being overly used, such that the user may distinguish one from the other. For example, when it is determined that the battery is being overly used, the LED may emit red light, and when it is determined that the battery is not being overly used, the LED may emit blue light.

FIG. 3B shows the notification unit 325 by locating a logo of a manufacturer of the electronic device 320 on a lower end portion of a monitor in the electronic device 320.

The logo of the manufacturer may be displayed in various colors by disposing a light emission device that may emit light beams of a plurality of colors under the logo of the manufacturer. For example, when it is determined that the battery is being overly used, the logo of the manufacturer may emit red light, and when it is determined that the battery is not being overly used, the logo of the manufacturer may emit blue light.

FIG. 3C shows the notification unit 335 by locating a plurality of LEDs on a right lower portion of a monitor of the electronic device 330. Each of the LEDs may emit a certain color light, and the user may distinguish a case where it is determined that the battery is being overly used from a case where it is determined that the battery is not being overly used, according to locations of the LEDs. For example, when a right LED among the LEDs forming the notification unit 335 emits a certain color light, it is determined that the battery is being overly used. In addition, when a left LED among the LEDs forming the notification unit 335 emits a certain color light, it is determined that the battery is not being overly used. The right LED and the left LED may emit the light of the same color, or different colors.

The color of light emitted from the notification units 315, 325, and 335 is not limited thereto, and shapes and locations of the notification units 315, 325, and 335 may be variously modified.

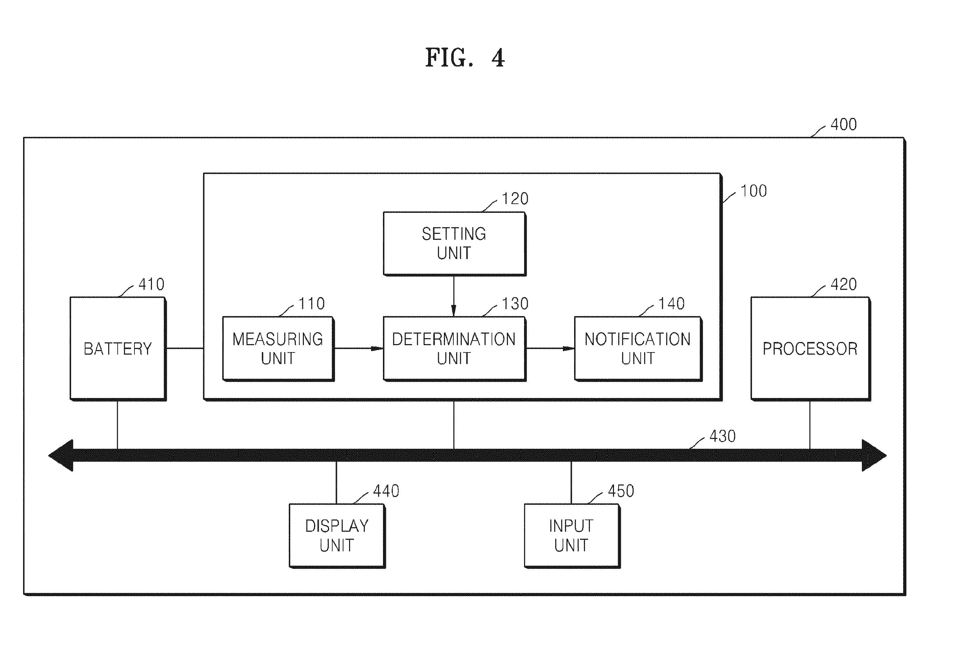

FIG. 4 is a block diagram of an electronic device 400 including the battery managing apparatus 100 shown in FIG. 1. The electronic device 400 may be a laptop computer, a cellular phone, a smart phone, a PDA, a PMP, an MP3 player, a tablet computer, a navigator, a digital camera, a camcorder, or the like. Referring to FIG. 4, the electronic device 400 includes the battery managing apparatus 100, a battery 410, a processor 420, a display unit 440, and an input unit 450. The above components may be connected to each other via a data bus 430. One of ordinary skill in the art would appreciate that other universal components may be included in the electronic device 400 in addition to the components shown in FIG. 4.

The battery managing apparatus 100 shown in FIG. 4 includes the measuring unit 110, the setting unit 120, the determination unit 130, and the notification unit 140, which are the same as those of the battery managing apparatus 100 shown in FIG. 1. Thus, detailed descriptions about the battery managing apparatus 100 will not be provided here.

The battery 410 supplies an electric power to drive the electronic device 400. The battery 410 may be various kinds of batteries that may be used in the electronic device 400, for example, the battery 410 may include a primary cell, as well as a secondary battery (rechargeable battery). For example, the secondary cell, such as a lithium ion battery, a lithium polymer battery, or a lithium-sulfur battery, or the primary cell, such as a manganese dry-cell, an alkaline battery, or a mercury battery, may be used as the battery 410.

The processor 420 may be a central processing unit (CPU), and may perform an overall control operation of the electronic device 400. In addition, the processor 420 receives a determination result of the determination unit 130 in the battery managing apparatus 100 via the data bus 430, and performs appropriate operations according to the consumption of the battery. For example, when it is determined that the battery is being overly used, the processor 420 may drive an adjustment interface to adjust the power consumption amount. A program about the adjustment interface may be stored in a storage unit (not shown) in the electronic device 400. The adjustment interface will be described later.

The display unit 440 may be any kind of display, through which the user may recognize information, for example, a liquid crystal display (LCD), a plasma display panel (PDP), an LED, or an active matrix organic light emitting diode (AMOLED). The display unit 440 displays information on a screen such that the user may sense the information visibly, on receiving a command of the processor 420. When the processor 420 drives the adjustment interface that adjusts the power consumption amount, the display 440 may display the adjustment interface.

The input unit 450 receives a command from a user to operate the electronic device 400. Any kind of input apparatus, to which the user may input a command, may be used as the input unit 450. For example, a keyboard, a mouse, a touch pad (electrostatic/piezoelectric type), a button, or a switch may be used as the input unit 450. The input unit 450 may receive a command from a user to control the adjustment interface displayed on the display unit 440.

According to the electronic device 400 of the present general inventive concept, the power consumption amount of the battery in real-time may be displayed directly to the user regardless of the operation system, and thus the user may easily check the using status of the battery. The user may use the electronic device 400 for a desired time period, and thus the electronic device 400 may be used effectively.

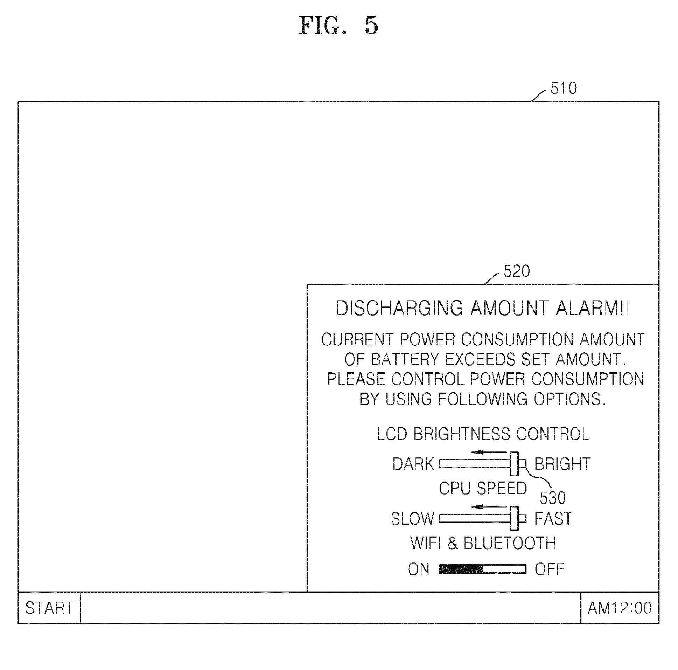

FIG. 5 is a diagram showing an example of the adjustment interface used in the electronic device 400 of FIG. 4. Referring to FIG. 5, the adjustment interface 520 may be displayed on a predetermined region on a display unit 510.

The adjustment interface 520 may include a message to notify the user that the battery 410 is being overly used, and may display settings of the electronic device 400, which may adjust the consumption of the battery, so as to control the settings of the electronic device 400 to allow the user to decrease the power consumption of the battery 410. For example, the adjustment interface 520 may represent information about at least one setting of the electronic device such as a speed of the processor 420, brightness of the display unit 440, and a communication type of the electronic device 400 so as to control them. The user may increase or decrease the speed of the processor 420, according to the kind of desired operation to be performed, may adjust the brightness of the display unit 420, according to a peripheral environment in which the electronic device 400 is located, and may turn off the setting of any unnecessary communication method that increases the power consumption of the battery 410, by using the input unit 450. For example, when the electronic device 400 is located in a dark place, the user may recognize the information even when the brightness of the display unit 440 is relatively lower than that of the display unit 440 in a bright place, and thus the brightness of the display unit 440 may be decreased in order to decrease the power consumption amount of the display unit 440. In addition, when a communication method such as WiFi or Bluetooth is not used, the communication setting is turned off in order to decrease the power consumption amount of the battery.

Also, the adjustment interface 520 may display a recommendation setting with respect to at least one setting so that the usage time of the electronic device 400 input by the user may be ensured. For example, if the power consumption of the battery has to be decreased in order to ensure the usage time input by the user, an arrow or a scale may represent an optical setting status such that the user may adjust at least one of the settings shown in the adjustment interface.

Referring to FIG. 5, settings of the electronic device 400 relating to the current power consumption of the battery 410 are shown in the adjustment interface 520. The user may manipulate a cursor 530 representing the current setting status on an optical setting status marked by the arrow by using the input unit 450, such as a mouse, and thus the consumption of the battery 410 may be decreased, and accordingly the usage time input by the user may be ensured.

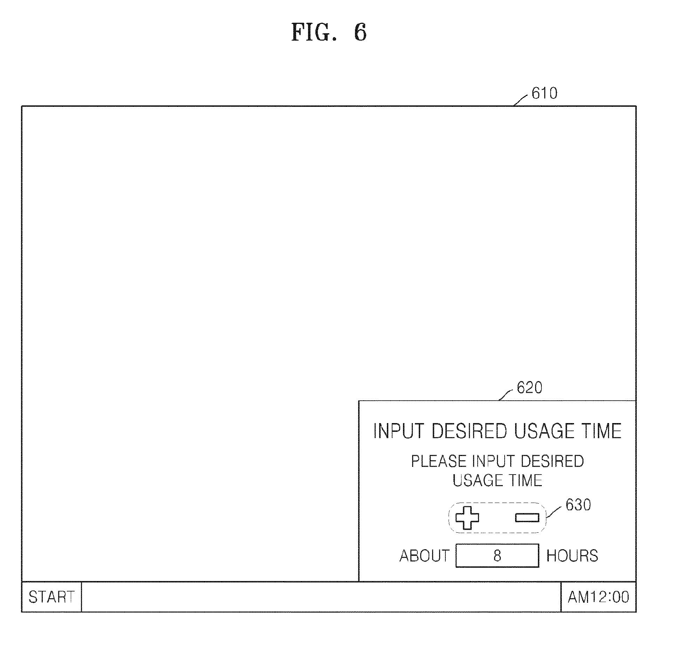

FIG. 6 is a diagram showing an example of realizing the setting unit of the battery managing apparatus as software in the electronic device shown in FIG. 4. Referring to FIG. 6, an input window 620 through which the user may input the desired usage time of the electronic device 400 is displayed on a certain region of a display unit 610.

The setting unit 120 of the battery managing apparatus 100 may be formed as hardware as shown in FIGS. 2A through 2D, however, the setting unit 120 may be formed as software as shown in FIG. 6 by using the other components of the electronic device 400 in which the battery managing apparatus 100 is mounted. The user may control the setting unit 620 by using the display unit 440 and the input unit 450 of the electronic device 400. The user may input the usage time by clicking an image 630, such as '+' or '-' displayed on the input window 620, by using the input unit 450, such as a mouse.

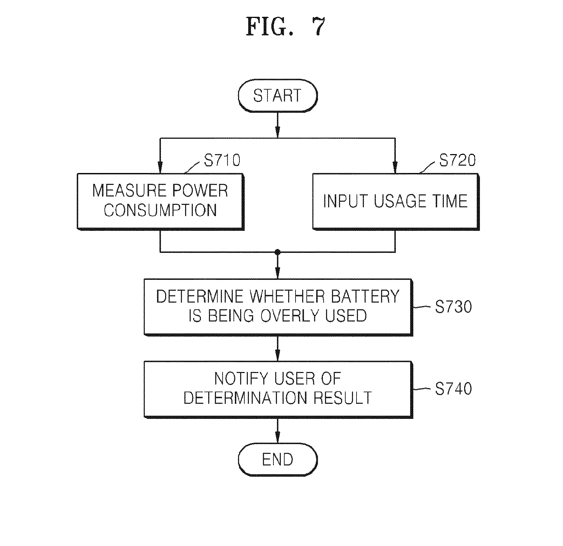

FIG. 7 is a flowchart illustrating a battery managing method according to an embodiment of the present general inventive concept. Even if not described here, the above described components for describing the battery managing apparatus 100 may be also applied to the battery managing method of the present general inventive concept.

The measuring unit 110 measures the power consumption amount of the battery of the electronic device in operation S710.

The setting unit 120 receives the desired usage time from the user of the electronic device in operation S720.

The determination unit 130 determines whether the battery is being overly used based on the reference power amount per unit time required to use the electronic device for the input usage time and the power consumption amount per unit time in operation S730.

The notification unit 140 notifies the user of the determination result in operation S740.

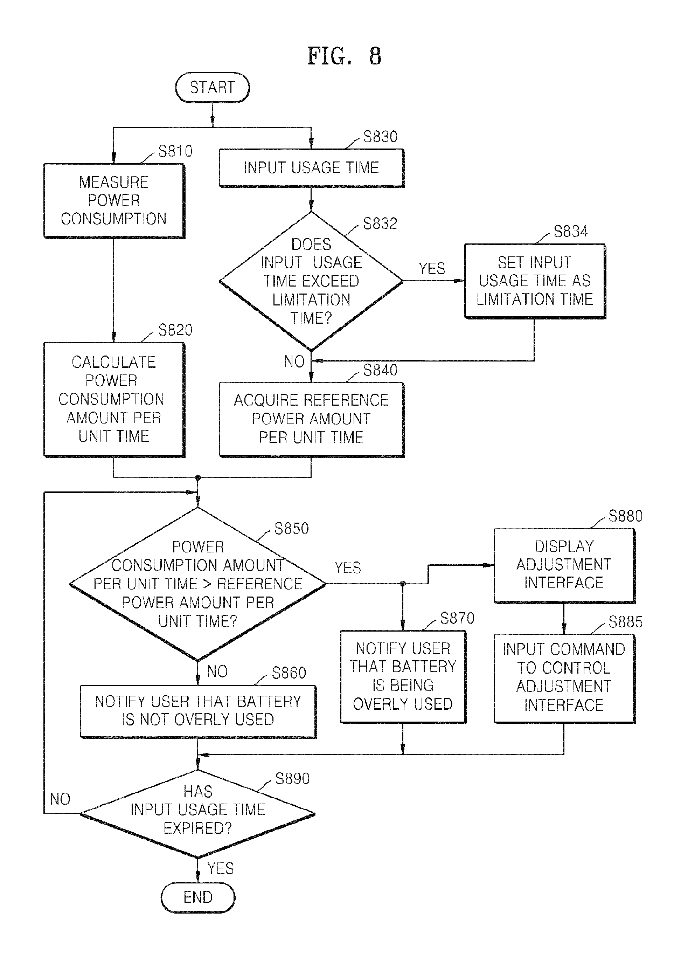

FIG. 8 is a detailed flowchart illustrating the battery managing method of an embodiment of the present general inventive concept. Hereinafter, even if not described here, the above described components for describing the battery managing apparatus 100 and the electronic device 400 may be also applied to the battery managing method of the present general inventive concept.

The measuring unit 110 measures the power consumption of the battery of the electronic device in operation S810. The measuring unit 110 may measure the power consumption by detecting a voltage or a current output from the battery. In this measurement step, the power consumption of the battery may be measured in real-time.

The determination unit 130 converts the measured power consumption into a power consumption amount per unit time in operation S820. That is, the power consumption for the unit time may be summed to calculate the power consumption amount. The unit time may be input from the user or may be set in advance.

The setting unit 120 receives the desired usage time of the electronic device from the user in operation S830.

The determination unit 130 checks whether the input usage time exceeds the usage limitation time of the electronic device in operation S832. The usage limitation time refers to a maximum usage time that is obtained when it is assumed that the electronic device 400 is used with a minimum power consumption amount required to operate the electronic device until the remaining capacity of the battery is completely consumed. The minimum power consumption amount required to operate the electronic device 400 is determined according to the internal structure of the electronic device 400 when the electronic device 400 is manufactured. Therefore, when the remaining capacity of the battery of the electronic device 400 is detected, the usage limitation time may be obtained by dividing the remaining capacity by the predetermined minimum power consumption amount. For example, when the remaining capacity of the battery having a capacity of 600 Wh is 300 Wh and the minimum power consumption amount to operate the electronic device 400 is 30 Wh, the usage limitation time is 10 hours. That is, even when the user inputs the usage time exceeding 10 hours, it may be checked whether the usage time input by the user exceeds the maximum usage time. When the input usage time does not exceed the usage limitation time, the process goes to S840, and when the input usage time exceeds the usage limitation time, the process goes to S834.

The determination unit 130 sets the input usage time as the usage limitation time when the input usage time exceeds the usage limitation time, in operation S834. That is, the usage time exceeding the limitation is lowered to the limitation time. When the setting of the usage time is finished, the process goes to S840.

The determination unit 130 acquires the reference power amount per unit time that is a power amount per unit time required to operate the electronic device 400 with the remaining capacity of the battery for the remaining time until the usage time input by the user expires in operation S840. After the user inputs the usage time, the usage time is decreased gradually as time elapses. The determination unit 130 calculates how much power has to be consumed per unit time in order to consume all the remaining capacity of the battery until the input usage time expires, based on the remaining capacity of the battery and the input usage time that are decreased as time elapses. For example, the remaining capacity of the battery is 300 Wh and the user inputs the usage time of 5 hours, an average power consumption amount that may be consumed by the electronic device for an hour is 60 W. Here, when the unit time is one minute, the power consumption amount consumed by the electronic device per unit time is 1 W, which becomes the reference power amount per unit time.

In operation S850, the determination unit 130 compares the reference power amount per unit time that is required to use the electronic device for the usage time input by the user with the power consumption amount per unit time, in order to determine whether the battery is being overly used or not. The determination unit 130 determines that the battery is being overly used when the power consumption amount per unit time exceeds the reference power amount per unit time, and determines that the battery is not being overly used when the power consumption amount per unit time does not exceed the reference power amount per unit time. For example, when the reference power amount per unit time is 1 W and the unit time is one minute, the power consumption amount consumed by the battery 410 of the electronic device 400 for one minute is calculated. Then, when the calculated value exceeds the reference power amount per unit time of 1 W, it is determined that the battery is being overly used.

In operation S860, when the determination unit 130 determines that the battery is not being overly used, the notification unit 140 notifies the user of the determination result.

In operation S870, when the determination unit 130 determines that the battery is being overly used, the notification unit 140 notifies the user of the determination result. When it is determined that the battery is being overly used, the following operations S880 and S885 may be performed.

In operation S880, when the determination unit 130 determines that the battery is being overly used, the processor 420 operates the adjustment interface through which the power consumption amount of the battery may be adjusted and displays the adjustment interface on the display unit 440.

In operation S885, the user inputs a command to control the adjustment interface into the input unit 450 in order to manipulate the adjustment interface displayed on the display unit 440.

In operation S890, it is determined whether the input usage time has expired. When the input usage time expires, it means that the user uses the electronic device for the desired usage time, and the processes are finished. However, if the input usage time has not expired yet, some of the processes may be repeatedly performed in order for the user to control the power consumption of the battery 410 of the electronic device 400. Before the input usage time expires, the determination unit 130 may repeatedly determine whether the battery is being overly used by comparing the power consumption amount per unit time with the reference power amount per unit time. In addition, the notification unit 140 may continuously notify the user of the determination results of the determination unit 130.

According to the embodiments of the present general inventive concept, the user may actively save energy, environmental contamination caused by excessive use of the energy may be restrained, and the battery may be efficiently used.

According to the present general inventive concept, the user is notified whether the battery is currently being overly used or not in order for the user to use the electronic device for a desired time period, and thus the user may be notified to decrease the battery consumption.

Although a few embodiments of the present general inventive concept have been shown and described, it will be appreciated by those skilled in the art that changes may be made in these embodiments without departing from the principles of the general inventive concept, the scope of which is defined in the appended claims and their equivalents.

## Claims

1. A battery managing method comprising:
measuring a power consumption amount of a battery in an electronic device;
receiving an input of a desired usage time of the electronic device from a user of the electronic device;
determining whether the battery is being overly used based on a reference power amount per unit time required to use the electronic device for the input usage time period and a power consumption amount per unit time; and
notifying the user of a result of the determining.

2. The battery managing method of claim 1, wherein the determining comprises:
converting the measured power consumption amount into the power consumption amount per unit time;
acquiring the reference power amount per unit time that is a power amount per unit time required to use the electronic device for the input usage time with a remaining capacity of the battery; and
determining whether the battery is being overly used according to a result of comparing the power consumption amount per unit time with the reference power amount per unit time.

3. The battery managing method of claim 2, wherein the determining determines that the battery is being overly used when the power consumption amount per unit time exceeds the reference power amount per unit time.

4. The battery managing method of any one of claims 1 to 3, wherein the determining and the notifying are repeatedly performed for the input usage time period.

5. The battery managing method of any one of claims 1 to 4, wherein the measuring of the power consumption is performed in real-time.

6. The battery managing method of any one of claims 1 to 5, wherein the receiving of the input of a desired usage time further comprises checking whether the input usage time exceeds a usage limitation time that is set in advance in the electronic device.

7. The battery managing method of claim 6, wherein the input usage time is set as the usage limitation time when the input usage time exceeds the usage limitation time.

8. The battery managing method of any one of claims 1 to 7, wherein the notifying of the determination result may be performed such that the user may distinguish a case where it is determined that the battery is being overly used from a case where it is determined that the battery is not being overly used.

9. The battery managing method of any one of claims 1 to 8, further comprising:
displaying an adjustment interface to adjust the power consumption amount when it is determined that the battery is being overly used according to the result of the determining; and
receiving an input to control the adjustment interface from the user.

10. A battery managing apparatus comprising:
a measuring unit arranged to measure a power consumption amount of a battery of an electronic device;
a setting unit arranged to receive a desired usage time of the electronic device from a user of the electronic device;
a determination unit arranged to determine whether the battery is being overly used based on a reference power amount per unit time required to use the electronic device for the input usage time period and a power consumption amount per unit time; and
a notification unit arranged to notify the user of a result of the determining.

11. The battery managing apparatus of claim 10, wherein the determination unit is arranged to convert the measured power consumption amount into a power consumption amount per unit time, to acquire the reference power amount per unit time that is a power amount per unit time required to use the electronic device for the input usage time with a remaining capacity of the battery, and to determine whether the battery is being overly used according to a result of comparing the power consumption amount per unit time with the reference power amount per unit time.

12. The battery managing apparatus of claim 10 or 11, wherein the measuring unit is arranged to measure the power consumption in real-time.

13. The battery managing apparatus of any one of claims 10 to 12, wherein the setting unit may be any one of a type selected from a group comprising a dial type, a button type, a switch type, and a sliding type.

14. The battery managing apparatus of any one of claims 10 to 13, wherein the notification unit is arranged to perform the notifying of the result of the determining such that the user may distinguish a case where it is determined that the battery is being overly used from a case where it is determined that the battery is not being overly used.

15. The battery managing apparatus of claim 14, wherein the notification unit comprises at least one light emitting device emitting light of different colors to correspond to each result of the determining.
